(19) **Europäisches Patentamt**

**European Patent Office**

**Office européen des brevets**

(11) **EP 0 880 836 B1**

(12) **EUROPÄISCHE PATENTSCHRIFT**

(45) Veröffentlichungstag und Bekanntmachung des Hinweises auf die Patenterteilung:
**13.08.2003 Patentblatt 2003/33**

(21) Anmeldenummer: **96946105.2**

(22) Anmeldetag: **19.12.1996**

(51) Int Cl.7: **H04L 1/00**, H03M 13/00

(86) Internationale Anmeldenummer:
**PCT/DE96/02465**

(87) Internationale Veröffentlichungsnummer:
**WO 97/030530 (21.08.1997 Gazette 1997/36)**

(54) **VERFAHREN ZUR AUFBEREITUNG VON DATEN, INSBESONDERE FÜR DIE ÜBERTRAGUNG MIT VERÄNDERLICHER KANALBITRATE**

PROCESS FOR EDITING OF DATA, IN PARTICULAR FOR TRANSMISSION WITH VARIABLE CHANNEL BIT RATE

PROCEDE POUR LA MISE EN FORME DES DONNEES, NOTAMMENT EN VUE DE LA TRANSMISSION A DEBIT BINAIRE DE CANAL VARIABLE

(84) Benannte Vertragsstaaten:
**CH DE DK ES FI FR GB IT LI NL SE**

(30) Priorität: **14.02.1996 DE 19605418**

(43) Veröffentlichungstag der Anmeldung:
**02.12.1998 Patentblatt 1998/49**

(73) Patentinhaber: **ROBERT BOSCH GMBH**
**70442 Stuttgart (DE)**

(72) Erfinder: **MUELLER, Joerg-Martin**
**D-71409 Schwaikheim (DE)**

(56) Entgegenhaltungen:
**EP-A- 0 643 493**

EP 0 880 836 B1

## Beschreibung

Die Erfindung geht aus von einem Verfahren zur Aufbereitung von Daten für die Übertragung über einen Kanal mit veränderbarer Kanalbitrate.

Stand der Technik

Der Standard H 324 M für mobile Videotelefonanwendungen läßt alle möglichen mobilen Funksysteme zu, so daß der Bedarf an verfügbarer Datenrate (Kanalbitrate) unterschiedlich sein kann. Selbst innerhalb eines Übertragungssystems kann die verfügbare Bitrate für Sprach- und Video-Kanalcodecs unterschiedlich sein.

Aus der DE 41 37 609 A1 ist ein Verfahren zum Decodieren von Binärsignalen von über einen Kanal übertragenen nach einem fehlerkorrigierenden Code aufbereiteten Binärsignalen bekannt. Die Bitfehlerwahrscheinlichkeit wird ausgewertet und eine Entscheidung getroffen, ob die empfangenen Bits richtig oder fehlerhaft sind.

Aus der EP-A-0643493 ist ein Fehlerkorrekturverfahren für ein digitales Zellenfunksystem bekannt. Die Daten werden dort in drei verschiedene Bitklassen mit unterschiedlichem Fehlerschutz aufgeteilt. Für die Aufteilung in die verschiedenen Bitklassen erfolgt eine Bewertung der Sprachabtastwerte nach der "A-Faktor-Analyse" und anhand von Sprechverständlichkeitstests.

Vorteile der Erfindung

Mit den Maßnahmen gemäß den Merkmalen des Patentanspruchs 1 läßt sich insbesondere eine Adaption eines Kanalcodec für beliebige Übertragungsverfahren erreichen. Die weiteren Ansprüche zeigen vorteilhafte Ausgestaltungen auf.

Im Gegensatz zu herkömmlichen Übertragungsverfahren muß nicht für jedes Übertragungssytem, zum Beispiel Mobilfunksystem, ein spezifischer Kanalcodec vorgesehen sein, zum Beispiel ein Kanalcodec speziell für GSM oder DECT. Die Erfindung arbeitet zuverlässig, selbst wenn die verfügbare Kanalbitrate unbekannt ist. Die Konfiguration eines Kanalencoders und eines entsprechenden Kanaldecoders hängt bei der Erfindung nur von der verfügbaren Kanalcodec-Bitrate ab. Eine Übertragung nach G.723.1 über Mobilfunkkanäle unterschiedlicher Kanalbitrate ist möglich, ohne Änderung der Kanalencoder oder -decoder. Die Kanalencoder beziehungsweise -decoder müssen lediglich skalierbar ausgebildet sein, das heißt in Abhängigkeit der Kanalbitrate wird die Coderate stufenweise verändert.

Zeichnungen

Figur 1 zeigt ein Blockschaltbild für die Datenaufbereitung bei der Erfindung,
Figur 2 zwei Vorschläge für die Bitverteilung auf die Bitklassen und die Gewichtsfaktoren der Bitklassen,
Figur 3 die Bitverteilung auf die Bitklassen sowie die Coderate für verschiedene Kanalbitraten und
Figur 4 eine ebensolche Verteilung für ein anderes Übertragungsverfahren.

Beschreibung von Ausführungsbeispielen

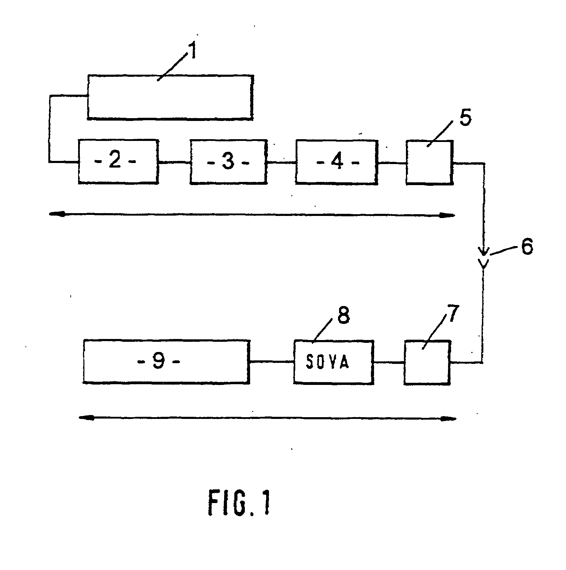

Wie in Figur 1 dargestellt ist, werden die aufzubereitenden Informationsbits eines Quellencoders 1 , beispielsweise gemäß dem Übertragungsstandard G. 723.1, in der Einheit 2 in Abhängigkeit ihrer Fehlerempfindlichkeit geordnet. Das empfindlichste Bit wird an die erste Stelle des geordneten Datenstroms gesetzt und das am wenigsten empfindliche Bit an die letzte Position. Die Ermittlung der Fehlerempfindlichkeit von Informationsbits basiert auf bekannten Meßverfahren, die im Zusammenhang mit der G.723.1 vorgeschlagen wurden. Der so geordnete Datenstrom wird nun in verschiedene Bitklassen $c[i]$ aufgeteilt - Block 3 - mit beispielsweise $i = 0,...,4$, wobei $c[0]$ die fehlerempfindlichsten Bits enthält und $c[4]$ die am wenigsten fehlerempfindlichsten Bits. Anschließend wird jeder Bitklasse ein Gewichtsfaktor $w[i]$, $i = 0,...,4$ - Block 4 - zugewiesen, zur Steuerung der Zuteilung der Bitrate (Coderate) $r$ für die einzelnen Bitklassen. Der Gewichtsfaktor $w[i]$ wird in Abhängigkeit von der mittleren Fehlerempfindlichkeit der jeweiligen Bitklasse $c[i]$ gewählt. Die Coderate $r$ gibt hierbei das Verhältnis der Anzahl der Informationsbits $k$ zur Anzahl der Übertragungsbits $n$ an (F.J. Furrer, Fehlerkorrigierende Block-Codierung für die Datenübertragung, Birkhäuser-Verlag, Basel, 1981, Seite 270):

$$r = k/n$$

Ist $r = 1$, werden die Informationsbits ungeschützt übertragen. Für $r = 1/2$ wird jedes Informationsbit mit einem redundanten Fehlerschutzbit versehen. Die Bits der Klasse 4 erhalten keinen Schutz. Die Klasse $c[0]$ enthält $c[0]$ -3 Informationsbits und drei parity check code bits, die an das Ende der Klasse $c[0]$ innerhalb eines Datenblocks gefügt werden. Die Datenblöcke mit den verschiedenen Bitklassen werden in einem Übertragungsrahmen untergebracht. Die Klasse $c[0]$ wird stets mit der höchsten Fehlerredundanz versehen, beispielsweise mit einer Minimum-Fehlerschutzrate (Coderate $r <= 1/2$). Die anderen Klassen haben keinen so hohen Fehlerschutz (Konstraint).

Vorzugsweise wird für die Übertragung ein kurzer Paritycheck-code (3 bit parity check code) verwendet, der als fehlererkennender Code im Kanaldecoder nicht korrigierte Fehler erkennen soll (bad frame detection). Insbesondere kann bei Verwendung eines Viterbi-Decoders die Softdecision-Ausgangsinformation der Einheit SOVA (Soft Decision Viterbi Algorithm) zur "bad frame detection" verwendet werden. Mit einer Constraint-Länge von 5 (16 Zustände) und einem Code der Coderate r = 1/3 läßt sich eine zuverlässige Übertragung mit vertretbarem Decoderaufwand realisieren. Höhere Konstraint-Längen führen zu keiner sinnvollen Erhöhung des Codiergewinns mehr. Höhere Coderaten können vom Ausgangscode der Rate 1/3 durch Codepunktierung abgeleitet werden. Die vier Bits (tail bits) zum Abschluß des Codes werden stets an das Ende der letzten geschützten Bitklasse gesetzt und erhalten die gleiche Coderate wie diese Klasse. Daraus ergibt sich eine minimale Anzahl von Kanalcodec-Bits pro Übertragungsrahmen zu:

$$B_{min} = c\,[0] + 4.$$

Die maximale Anzahl von Kanalcodec-Bits pro Übertragungsrahmen wird erreicht, wenn alle Klassen die Coderate r = 1/3 inclusive Fehlerschutz aufweisen:

$$B_{max} = 2 * \sum_{i=0}^{3} c[i] + 4\,.$$

Wenn pro Übertragungsrahmen B > $B_{min}$ Bits verfügbar sind, werden in einem ersten Durchgang die mittleren Coderaten r' [i], i = 0,...4 der Klassen zum Beispiel nach folgender Beziehung bestimmt:

$$r'[i] = \frac{12}{MIN[36,\ NINT(12*(1+\frac{B=w[i]}{c[i]}))]}$$

NINT bedeutet hier die Rundung zur nächstgelegenen ganzen Zahl. Für die Coderate der Bitklasse Null muß folgende Bedingung gelten:

$$r'[0] <= 12/24$$

Die Bedingung

$$\sum_{i=0}^{4} w[i] = 1.$$

muß ebenfalls eingehalten werden.

Um die Kanalcodec-Bits effizient zu verteilen, insbesondere für Mobilfunk-Anwendungen, wird eine zusätzliche Redundanz für die Coderate nach folgender Beziehung angewandt:

$$r[i] = \begin{cases} 1 & \text{if } r'[i] > \frac{12}{20} \\ r'[i] & \text{sonst} \end{cases}$$

Wenn mit obigen Beziehungen weniger Bits für eine Klasse zugeteilt werden als es der Kapazität eines Blockes im Übertragungsrahmen entspricht, das heißt dieser Block nicht voll ausgefüllt ist, werden in einem zweiten Durchgang Bits der Klasse i (i>1) in die Klasse i -1 mit der nächsthöheren Fehlerempfindlichkeit übernommen bis alle Bits den entsprechenden Bitklassen zugewiesen sind.

Wenn mehr Bits einer Bitklasse zugewiesen wurden, als es der Kapazität ihres Blockes im Übertragungsrahmen entspricht, werden im zweiten Durchgang Bits der Klasse i (i<4) in die Klasse i +1 übernommen, bis die maximal mögliche Coderate erreicht ist.

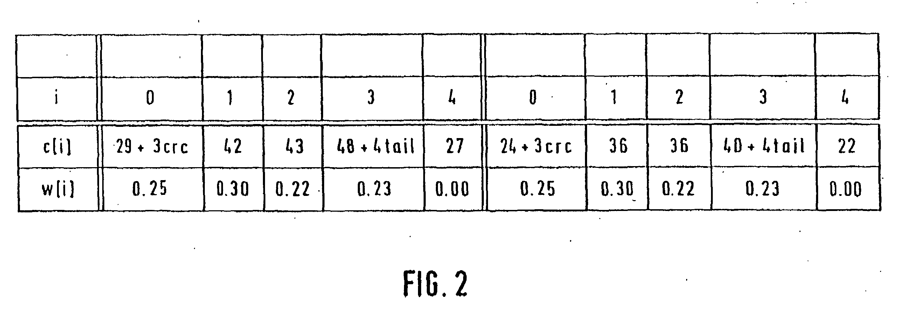

In der Figur 2 sind zwei mögliche Vorschläge für die Bitverteilung und die Bewertung mit den Gewichtsfaktoren w [i] dargestellt. Die Konfiguration ist etwas modifiziert. Die "tail bits" werden in der Klasse mit der geringsten Fehlerredundanzübertragung (dies ist die Klasse 3, da die Klasse 4 ungeschützt übertragen wird). Die "parity check code bits" für die Fehlererkennung der ersten Klasse sind mit crc bezeichnet.

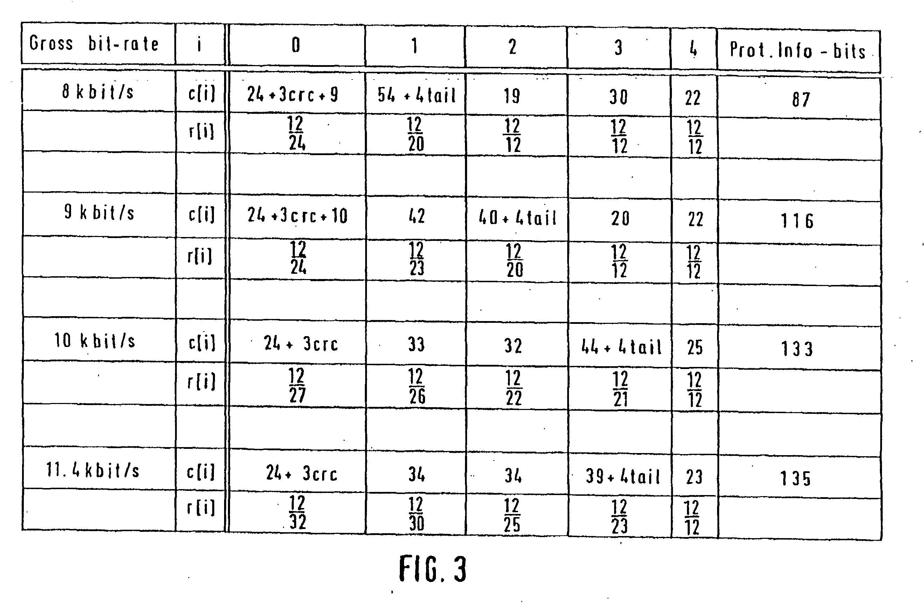

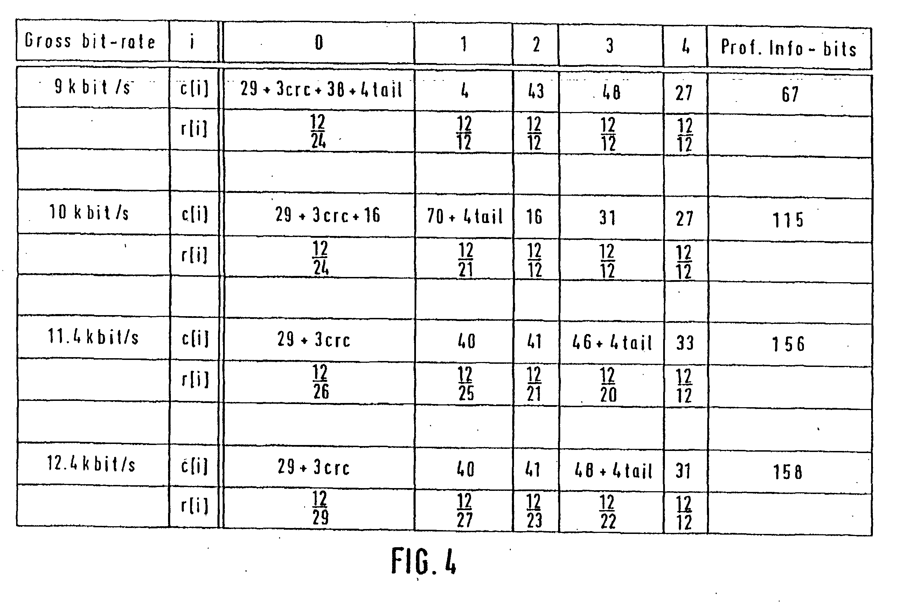

Figur 3 zeigt eine Tabelle für die vorgebbar veränderlichen Datenraten (Kanalbitraten) 8.0, 9.0, 10.0 und 11.4 Kbit/s mit der Bitverteilung und der entsprechenden Coderate r [i]. Für andere Übertragungsnormen, beispielsweise gemäß G.723.1, ergeben sich andere Bitverteilungen und Coderaten (Figur 4).

Das Verfahren nach der Erfindung wird insbesondere während einer Verbindungsaufbauphase in Verbindung mit einem Kanalcoder 5 und dem entsprechenden Kanaldecoder 7 durchgeführt oder jedes Mal, wenn die variable Kanalbitrate gewechselt wird. Dies ist theoretisch für jeden Übertragungsrahmen möglich. Der Übertragungskanal 6 ist zwischen Kanalcoder 5 und Kanaldecoder 7 vorgesehen. Der Quelldecoder 9 schließt sich an die Soft-Decision-Einheit 8 an.

Bei der Erfindung wird die Zuteilung der Fehlerredundanz für jede der Bitklassen kontinuierlich verändert und zwar in Abhängigkeit der vorgebbar veränderlichen Kanalbitrate. Die im Übertragungsrahmen zur Verfügung stehende Anzahl von Redundanzbits wird so mittels einer Zuordnungsvorschrift optimal auf die Bitklassen verteilt, wobei sich die Anzahl der Redundanzbits in 1-Bit-Schritten verändern darf.

**Patentansprüche**

1. Verfahren zur Aufbereitung von Daten für die Übertragung über einen Kanal mit vorgebbar veränderlicher Datenrate, wobei folgende Maßnahmen durchgeführt werden:

   - Die Daten werden in verschiedene Bitklassen (c [i]) entsprechend ihrer Fehlerempfindlichkeit aufgeteilt (3),

   - die so aufgeteilten Bitklassen (c [i]) werden mit Gewichtsfaktoren bewertet (4) und mit unterschiedlicher Fehlerredundanz versehen, **gekennzeichnet durch**:

       - eine Aufteilung derart, daß die Bitklasse/n (c [i]) mit den fehlerempfindlichsten Bits eine höhere Fehlerredundanz erhält/erhalten,

       - jede Bitklasse (c [i]) wird mit einem vorgegebenen Gewichtsfaktor (w [i]) bewertet, der abhängig von der mittleren Fehlerempfindlichkeit der jeweiligen Bitklasse (c [i]) gewählt wird,

       - die Zuteilung der Coderate (r) der einzelnen Klassen wird in Abhängigkeit der jeweiligen Gewichtsfaktoren (w [i]) gesteuert.

2. Verfahren nach Anspruch 1, **dadurch gekennzeichnet, daß** die Zuteilung der Fehlerredundanz für jede Bitklasse kontinuierlich verändert wird in Abhängigkeit der vorgebbar veränderlichen Kanalbitrate.

3. Verfahren nach einem der Ansprüche 1 oder 2, **dadurch gekennzeichnet, daß** die Fehlerredundanz für die Bitklasse (c [i]) mit der höchsten Fehlerempfindlichkeit so gewählt wird, daß die Bitrate, das heißt das Verhältnis von Informations- zu den Übertragungsbits, kleiner oder gleich 1/2 ist.

4. Verfahren nach einem der Ansprüche 1 3, **dadurch gekennzeichnet, daß** für die Bitklasse (c [4]) mit der niedrigsten Fehlerempfindlichkeit die Fehlerredundanz zu Null gewählt wird.

5. Verfahren nach einem der Ansprüche 1 bis 4, **dadurch gekennzeichnet, daß** die Bitklassen (c [i]) blockweise geordnet in einem Übertragungsrahmen untergebracht werden.

6. Verfahren nach einem der Ansprüche 1 bis 5, **dadurch gekennzeichnet, daß** die Fehlerredundanz für eine Bitklasse nur so weit erhöht wird, wie ein noch sinnvoller Codiergewinn erreichbar ist.

7. Verfahren nach Anspruch 5 oder 6, **dadurch gekennzeichnet, daß** die Fehlerredundanz jeweils am Ende einer Bitklasse im entsprechenden Block untergebracht wird.

8. Verfahren nach einem der Ansprüche 5 bis 7, **dadurch gekennzeichnet, daß** für den Fall, daß eine Bitklasse die Kapazität eines Blockes im Übertragungsrahmen nicht voll ausfüllt, Bits einer Bitklasse mit niedrigerer Fehlerempfindlichkeit in die Bitklasse mit der nächsthöheren Fehlerempfindlichkeit übernommen werden.

9. Verfahren nach einem der Ansprüche 5 bis 7, **dadurch gekennzeichnet, daß** für den Fall, daß einer Bitklasse mehr Bits zugewiesen werden als es der Kapazität ihres Blockes im Übertragungsrahmen entspricht, Bits einer Bitklasse mit höherer Fehlerempfindlichkeit in die Bitklasse mit der nächstniedrigeren Fehlerempfindlichkeit übernommen werden.

10. Verfahren nach einem der Ansprüche 1 bis 9, zur Durchführung während einer Verbindungsaufbauphase in einem Kanalcoder und dem entsprechenden Kanaldecoder.

11. Verfahren nach einem der Ansprüche 1 bis 9, zur Durchführung während eines vorgegebenen Kanalbitratenwechsels in einem Kanalcoder (5) und dem entsprechenden Kanaldecoder (7).

**Claims**

1. Method for preparing data for transmission via a channel with a prescribably variable data rate, the following measures being carried out:

   - the data are subdivided (3) into different bit classes (c [i]) in accordance with their error sensitivity,

   - the bit classes (c [i]) thus subdivided are evaluated (4) with the aid of weighting factors and provided with different error redundancy, **characterized by**:

       - a subdivision in such a way that the bit class(es) (c [i]) with the bits most sensitive to error receives/receive a higher error redundancy,

       - each bit class (c [i]) is evaluated with the aid of a prescribed weighting factor (w [i]) which is selected as a function of the mean error sensitivity of the respective bit class (c [i]), and

- the allocation of the code rate (r) to the individual classes is controlled as a function of the respective weighting factors (w [i]).

2. Method according to Claim 1, **characterized in that** the allocation of the error redundancy for each bit class is varied continuously as a function of the prescribably variable channel bit rate.

3. Method according to one of Claims 1 or 2, **characterized in that** the error redundancy for the bit class (c [i]) is selected with the highest error sensitivity such that the bit rate, that is to say the ratio of information bits to the transmission bits, is less than or equal to 1/2.

4. Method according to one of Claims 1 to 3, **characterized in that** the error redundancy is selected as zero for the bit class (c [i]) with the lowest error sensitivity.

5. Method according to one of Claims 1 to 4, **characterized in that** the bit classes (c [i]) are accommodated, ordered in blockwise fashion, in a transmission frame.

6. Method according to one of Claims 1 to 5, **characterized in that** the error redundancy for a bit class is increased only until it is possible to achieve an even more reasonable coding gain.

7. Method according to Claim 5 or 6, **characterized in that** the error redundancy is respectively accommodated at the end of a bit class in the appropriate block.

8. Method according to one of Claims 5 to 7, **characterized in that** in the case when a bit class does not completely fill up the capacity of a block in the transmission frame, bits of a bit class with lower error sensitivity are taken over into the bit class with the next higher error sensitivity.

9. Method according to one of Claims 5 to 7, **characterized in that** in the case when a bit class is assigned more bits than correspond to the capacity of its block in the transmission frame, bits of a bit class with higher error sensitivity are taken over into the bit class with the next lower error sensitivity.

10. Method according to one of Claims 1 to 9, for carrying out during a call set up phase in a channel coder and the corresponding channel decoder.

11. Method according to one of Claims 1 to 9, for carrying out during a prescribed change in channel bit rate in a channel coder (5) and the corresponding channel decoder (7).

**Revendications**

1. Procédé de mise en forme de données à transmettre par un canal à des débits de données variables d'une manière qui peut être prédéfinie, en appliquant les dispositions suivantes :

   - les données sont réparties en différentes classes de bits (c[i]) correspondant à leur vulnérabilité aux erreurs,
   - les classes de bits (c[i]) résultant de cette répartition sont valorisées par des facteurs de pondération (4) et dotées de redondances de protection contre les erreurs différentes,

   **caractérisé en ce que**

   - la répartition est effectuée de manière que la (les) classe(s) (c[i]) contenant les bits les plus vulnérables à l'erreur reçoit (reçoivent) une redondance de protection contre les erreurs plus élevée,
   - chaque classe de bits (c[i]) est valorisée par un facteur de pondération (w[i]), choisi en fonction de la vulnérabilité moyenne à l'erreur de cette classe,
   - l'attribution des débits de code (r) des différentes classes est commandée en fonction des facteurs de pondération (w[i]) correspondants.

2. Procédé selon la revendication 1, **caractérisé en ce que** l'attribution de la redondance de protection contre les erreurs à chaque classe varie continuellement en fonction des débits de canal variant de manière prédéfinie.

3. Procédé selon l'une des revendications 1 ou 2, **caractérisé en ce que** la redondance de protection contre les erreurs pour la classe (c[i]) présentant la plus forte vulnérabilité à l'erreur est choisie de manière que le débit binaire (c[i]), c'est-à-dire le rapport des bits d'information aux bits de transmission est au plus égal à 1/2.

4. Procédé selon l'une des revendications 1 à 3, **caractérisé en ce que** pour la classe de bits (c[4]) présentant la plus faible vulnérabilité à l'erreur, la redondance d'erreurs est choisie égale à zéro.

5. Procédé selon l'une des revendications 1 à 4, **caractérisé en ce que** les classes de bits (c[i]) sont ordonnées par blocs dans une séquence de transmission.

6. Procédé selon l'une des revendications 1 à 5, **caractérisé en ce que**

la redondance pour une classe de bits est élevée au dernier niveau apportant encore un gain de code significatif.

7. Procédé selon l'une des revendications 5 ou 6, **caractérisé en ce que** la redondance est placée chaque fois à la fin d'une classe de bits dans le bloc correspondant.

8. Procédé selon l'une des revendications 5 à 7, **caractérisé en ce que** dans le cas où à une classe de bits ne remplit pas totalement la capacité d'un bloc dans la séquence de transmission, des bits et une classe de bits présentant une moindre vulnérabilité à l'erreur sont pris dans la classe de bits présentant la vulnérabilité supérieure la plus proche.

9. Procédé selon l'une des revendications 5 à 7, **caractérisé en ce que** dans le cas où à une classe de bits sont affectés, dans une séquence de transmission, un nombre de bits dépassant la capacité de son bloc, des bits d'une classe de bits à vulnérabilité à l'erreur plus élevée sont pris dans la classe de bits présentant la vulnérabilité supérieurs la plus proche.

10. Procédé selon l'une des revendications 1 à 9, **caractérisé en ce qu'** il est destiné à être mis en oeuvre pendant une phase d'établissement de liaison dans un codeur de canal et dans le décodeur correspondant.

11. Procédé selon l'une des revendications 1 à 9, **caractérisé en ce qu'** il est destiné à être mis en oeuvre pendant un changement prédéfini de débit binaire de canal dans un codeur de canal (5) et dans le décodeur de canal (7) correspondant.

FIG.1

EP 0 880 836 B1

| i | 0 | 1 | 2 | 3 | 4 | 0 | 1 | 2 | 3 | 4 |
|---|---|---|---|---|---|---|---|---|---|---|
| c[i] | 29 + 3crc | 42 | 43 | 48 + 4tail | 27 | 24 + 3crc | 36 | 36 | 40 + 4tail | 22 |
| w[i] | 0.25 | 0.30 | 0.22 | 0.23 | 0.00 | 0.25 | 0.30 | 0.22 | 0.23 | 0.00 |

FIG. 2

| Gross bit-rate | i | 0 | 1 | 2 | 3 | 4 | Prot.Info - bits |
|---|---|---|---|---|---|---|---|
| 8 kbit/s | c[i] | 24 + 3crc + 9 | 54 + 4tail | 19 | 30 | 22 | 87 |
| | r[i] | $\frac{12}{24}$ | $\frac{12}{20}$ | $\frac{12}{12}$ | $\frac{12}{12}$ | $\frac{12}{12}$ | |
| | | | | | | | |
| 9 kbit/s | c[i] | 24 + 3crc + 10 | 42 | 40 + 4tail | 20 | 22 | 116 |
| | r[i] | $\frac{12}{24}$ | $\frac{12}{23}$ | $\frac{12}{20}$ | $\frac{12}{12}$ | $\frac{12}{12}$ | |
| | | | | | | | |
| 10 kbit/s | c[i] | 24 + 3crc | 33 | 32 | 44 + 4tail | 25 | 133 |
| | r[i] | $\frac{12}{27}$ | $\frac{12}{26}$ | $\frac{12}{22}$ | $\frac{12}{21}$ | $\frac{12}{12}$ | |
| | | | | | | | |
| 11.4 kbit/s | c[i] | 24 + 3crc | 34 | 34 | 39 + 4tail | 23 | 135 |
| | r[i] | $\frac{12}{32}$ | $\frac{12}{30}$ | $\frac{12}{25}$ | $\frac{12}{23}$ | $\frac{12}{12}$ | |

FIG. 3

EP 0 880 836 B1

| Gross bit-rate | i | 0 | 1 | 2 | 3 | 4 | Prof. Info - bits |
|---|---|---|---|---|---|---|---|
| 9 kbit/s | c[i] | 29 + 3crc + 38 + 4tail | 4 | 43 | 48 | 27 | 67 |
| | r[i] | $\frac{12}{24}$ | $\frac{12}{12}$ | $\frac{12}{12}$ | $\frac{12}{12}$ | $\frac{12}{12}$ | |
| | | | | | | | |
| 10 kbit/s | c[i] | 29 + 3crc + 16 | 70 + 4tail | 16 | 31 | 27 | 115 |
| | r[i] | $\frac{12}{24}$ | $\frac{12}{21}$ | $\frac{12}{12}$ | $\frac{12}{12}$ | $\frac{12}{12}$ | |
| | | | | | | | |
| 11.4 kbit/s | c[i] | 29 + 3crc | 40 | 41 | 46 + 4tail | 33 | 156 |
| | r[i] | $\frac{12}{26}$ | $\frac{12}{25}$ | $\frac{12}{21}$ | $\frac{12}{20}$ | $\frac{12}{12}$ | |
| | | | | | | | |
| 12.4 kbit/s | c[i] | 29 + 3crc | 40 | 41 | 48 + 4tail | 31 | 158 |
| | r[i] | $\frac{12}{29}$ | $\frac{12}{27}$ | $\frac{12}{23}$ | $\frac{12}{22}$ | $\frac{12}{12}$ | |

FIG. 4

EP 0 880 836 B1